# EUROPEAN PATENT APPLICATION

(11) **EP 4 611 030 A2**
(43) Date of publication of application: **03.09.2025**
(21) Application number: 25160499.7
(22) Date of filing: 27.02.2025
(51) Int. Cl.: H01L 21/683, H01L 21/687

(54) **SUBSTRATE HOLDING APPARATUS, SUBSTRATE PROCESSING APPARATUS, SUBSTRATE HOLDING METHOD, SUBSTRATE PROCESSING METHOD, AND ARTICLE MANUFACTURING METHOD**

(30) Priority: 28.02.2024 JP 2024028930; 12.02.2025 JP 2025020993
(71) Applicant: CANON KABUSHIKI KAISHA, Tokyo 146-8501 (JP)
(72) Inventor: YANAGITA, Naoki, Ohta-ku, Tokyo, 146-8501 (JP); KOYA, Shigeo, Ohta-ku, Tokyo, 146-8501 (JP); NAKAJIMA, Kazunori, Ohta-ku, Tokyo, 146-8501 (JP); MORIKUNI, Yuichiro, Ohta-ku, Tokyo, 146-8501 (JP); WATANABE, Hikari, Ohta-ku, Tokyo, 146-8501 (JP)
(74) Representative: TBK

(57) **Abstract**

A substrate holding apparatus (10) that holds a substrate (S), comprising: a chuck (11) configured to support the substrate; pins (13) configured to protrude from the chuck; a controller (30) configured to control exhaust of a space between the substrate and the chuck, wherein the controller is configured to control the exhaust to perform a first exhaust operation of exhausting gas from the space with a first exhaust pressure, and after the first exhaust operation, perform a second exhaust operation of exhausting gas from the space with a second exhaust pressure lower than the first exhaust pressure, and wherein the second exhaust operation is performed in a period from when a protrusion amount of the pins start to decrease until when the chuck and the substrate come into contact with each other.

## Description

### BACKGROUND OF THE INVENTION

### Field of the Invention

The present disclosure relates to a substrate holding apparatus, a substrate processing apparatus, a substrate holding method, a substrate processing method, and an article manufacturing method.

### Description of the Related Art

A manufacturing process for semiconductor devices, liquid crystal display devices, and the like uses a chuck that holds a substrate by vacuum suction. When such a chuck is made to hold a substrate, stress may act on the substrate to cause distortion in the substrate depending on the magnitude of vacuum suction. Japanese Patent Laid-Open No. 2012-227554 discloses a method of causing a support structure (chuck) on a substrate table to clamp a substrate and then temporarily reducing the clamp force of the chuck after the lapse of a given time.

An apparatus including a chuck is used to improve the throughput as well as reducing the distortion in the substrate. The method disclosed in Japanese Patent Laid-Open No. 2012-227554 is disadvantageous in throughput.

### SUMMARY OF THE INVENTION

The present disclosure provides, for example, a technique advantageous in terms of distortion in a substrate and throughput in a process of causing a chuck to hold the substrate.

The present invention in its first aspect provides a substrate holding apparatus as specified in claims 1 to 13.

The present invention in its second aspect provides a substrate processing apparatus as specified in claim 14.

The present invention in its third aspect provides a substrate holding method as specified in claims 15 and 16.

The present invention in its fourth aspect provides a substrate processing method as specified in claim 17.

The present invention in its fifth aspect provides an article manufacturing method as specified in claim 18.

Further features of the present disclosure will become apparent from the following description of exemplary embodiments with reference to the attached drawings.

### BRIEF DESCRIPTION OF THE DRAWINGS

Fig. 1 is a schematic view showing an example of the arrangement of an exposure apparatus (substrate processing apparatus).
Fig. 2 is a schematic diagram showing an example of the arrangement of a substrate conveying system.
Fig. 3 is a schematic view showing an example of the arrangement of a substrate holding unit.
Fig. 4 is a schematic view showing an example of the arrangement of the substrate holding unit.
Figs. 5A and 5B are schematic views showing an example of the arrangement of a substrate chuck.
Figs. 6A to 6C are views for explaining a substrate holding process according to the first embodiment.
Figs. 7A to 7C are views for explaining the substrate holding process according to the first embodiment.
Fig. 8 is a view showing an example of the exhaust operation in a substrate mounting process according to the first embodiment.
Fig. 9 is a view showing a modification of the exhaust operation in the substrate mounting process according to the first embodiment.
Fig. 10 is a view showing an example of an exhaust operation in a substrate mounting process according to the second embodiment.
Fig. 11 is a view showing a modification of the exhaust operation in the substrate mounting process according to the second embodiment.
Fig. 12 is a view showing the monitoring result obtained by a pressure sensor in a substrate mounting process.
Figs. 13A to 13C are views for explaining the substrate holding process according to the fourth embodiment.
Fig. 14 is a view showing example of an exhaust operation in a substrate mounting process according to the fourth embodiment.
Figs. 15A to 15C are views for explaining the substrate holding process according to the fifth embodiment.
Fig. 16 is a view showing an example of an exhaust operation in the substrate mounting process according to the fifth embodiment.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an embodiment that uses all such features, and multiple such features may be combined as appropriate. Furthermore, in the attached drawings, the same reference numerals are given to the same or similar configurations, and redundant description thereof is omitted.

In the specification and the accompanying drawings, directions will be indicated on an XYZ coordinate system in which directions parallel to a surface (substrate holding surface) of a chuck that holds a substrate defined as the X-Y plane. Directions parallel to the X-axis, the Y-axis, and the Z-axis of the XYZ coordinate system are defined as the X direction, the Y direction, and the Z direction, respectively. A rotation about the X-axis, a rotation about the Y-axis, and a rotation about the Z-axis are defined as θX, θY, and θZ, respectively. Control and driving (movement) concerning the X-axis, the Y-axis, and the Z-axis mean control or driving (movement) concerning a direction parallel to the X-axis, a direction parallel to the Y-axis, and a direction parallel to the Z-axis, respectively. In addition, control or driving concerning the θX-axis, the θY-axis, and the θZ-axis means control or driving concerning a rotation about an axis parallel to the X-axis, a rotation about an axis parallel to the Y-axis, and a rotation about an axis parallel to the Z-axis, respectively.

### <First Embodiment>

A substrate processing apparatus according to the first embodiment of the present disclosure will be described. This embodiment will exemplify, as a substrate processing apparatus that processes a substrate, an exposure apparatus which is one of lithography apparatuses for manufacturing semiconductor devices, liquid crystal display devices, and the like. The exposure apparatus is an apparatus that performs an exposure process of transferring the pattern formed on an original onto a substrate by exposing the substrate to light using a step-and-repeat scheme or step-and-scan scheme.

In this case, the substrate processing apparatus according to the present disclosure is not limited to an exposure apparatus and may be another type of lithography apparatus such as an imprint apparatus or drawing apparatus. The imprint apparatus is an apparatus that forms a pattern of a curable material onto which a pattern on a mold is transferred by bringing an imprint material supplied onto a substrate into contact with the mold and applying energy for curing to the imprint material. The drawing apparatus is an apparatus that forms a pattern (latent image pattern) on a substrate by drawing on the substrate with a charged particle beam (electron beam) or laser beam. Alternatively, a substrate processing apparatus according to the present disclosure may be an apparatus other than lithography apparatuses, such as various types of high-precision processing apparatuses and various types of high-precision measuring apparatuses. The high-precision processing apparatus is an apparatus that performs a processing treatment of processing a substrate. The high-precision measuring apparatus is an apparatus that performs a measuring process of measuring a substrate.

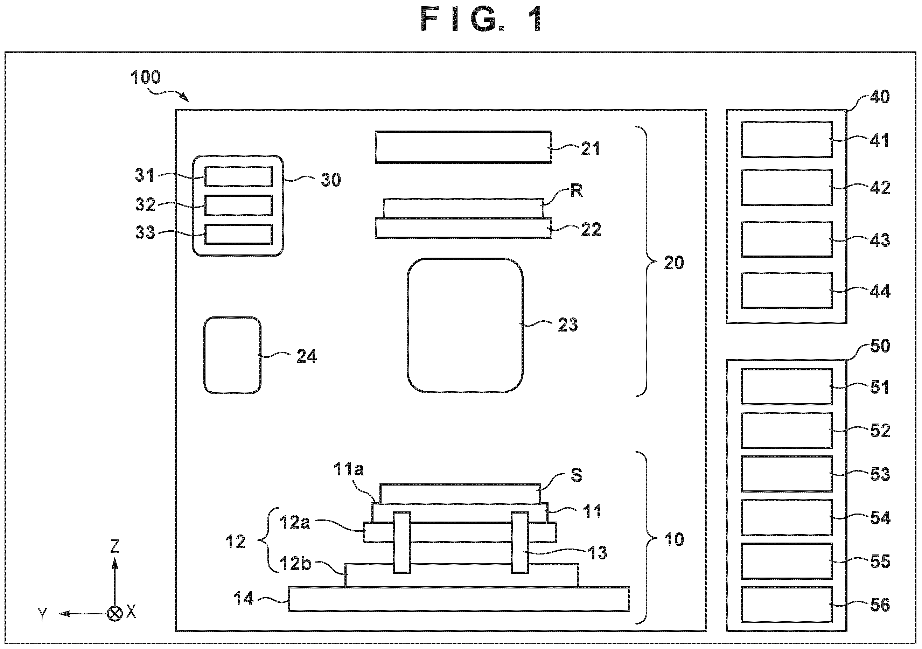

Fig. 1 is a schematic view showing an example of the arrangement of an exposure apparatus 100 according to this embodiment. The exposure apparatus 100 according to the embodiment can include a substrate holding unit 10 that holds a substrate S, a processor 20 that processes the substrate S, and a controller 30. The exposure apparatus 100 can also include an original conveying system 40 that conveys an original R to the processor 20 and a substrate conveying system 50 that conveys the substrate S to the substrate holding unit 10. Note that a reticle, mask, or the like is used as the original R, and a wafer, glass plate, or the like is used as the substrate S.

The substrate holding unit 10 can include a substrate chuck 11, a substrate stage 12, and pins 13. Note that the substrate holding unit 10 according to this embodiment can be provided with three pins 13. Limitation is not made thereto, and four or more pins 13 may be provided.

The substrate chuck 11 has a holding surface 11a (substrate holding surface) that holds the substrate S, and exhaust holes 11b through which gas is exhausted from the space on the substrate chuck 11 to hold the substrate S by vacuum suction. In the following description, exhausting (evacuating, expelling) gas from the space on the substrate chuck 11 through the exhaust holes 11b is sometimes simply referred to as "exhaust". The detailed arrangement of the substrate chuck 11 will be described later.

The substrate stage 12 is constituted by a fine-motion stage 12a and a coarse-motion stage 12b. The fine-motion stage 12a is configured to support the substrate chuck 11 and be movable on the coarse-motion stage 12b. The substrate stage 12 can include a driving mechanism (for example, a linear motor) for translationally driving the fine-motion stage 12a in the X direction, the Y direction, and the Z direction and rotationally driving the fine-motion stage 12a in θX direction, the θY direction, and the θZ direction. The coarse-motion stage 12b is configured to be movable on a platen 14. The substrate stage 12 can include a driving mechanism (for example, a linear motor) for translationally driving the coarse-motion stage 12b in the X direction, the Y direction, and the Z direction and rotationally driving the coarse-motion stage 12b in θX direction, the θY direction, and the θZ direction.

The pins 13 are members that are used to convey the substrate S to the substrate holding unit 10 with a supply hand 51 (to be described later) and to recover the substrate S from the substrate holding unit 10 with a recovery hand 52 (to be described later). The pins 13 extend along the Z direction and are fixed to the coarse-motion stage 12b. The pins 13 are configured to protrude from the holding surface 11a of the substrate chuck 11 and hold the substrate S by vacuum suction. The protrusion amount of the pins 13 from the holding surface 11a of the substrate chuck 11 can be controlled by relatively driving the substrate chuck 11 and the pins 13. This embodiment will exemplify a case where the substrate chuck 11 and the pins 13 are relatively driven by driving the fine-motion stage 12a that supports the substrate chuck 11 in the Z direction relative to the coarse-motion stage 12b. However, limitation is not made thereto. For example, the substrate chuck 11 and the pins 13 may be relatively driven by driving the coarse-motion stage 12b, to which the pins 13 are fixed, in the Z direction relative to the fine-motion stage 12a.

In this case, the position of the substrate stage 12 (the fine-motion stage 12a) can be measured by a position measuring unit (not shown). The position measuring unit includes, for example, a laser interferometer. In this case, the position measuring unit can measure the position of the substrate stage 12 by irradiating the substrate stage 12 with light and obtaining the displacement amount of the substrate stage 12 based on the light reflected by the substrate stage 12. Note that the position measuring unit that measures the position of the substrate stage 12 may include an encoder instead of the laser interferometer. In addition, the relative position between the fine-motion stage 12a and the coarse-motion stage 12b is measured by, for example, a capacitance sensor. The position of the coarse-motion stage 12b is controlled so as to follow the position of the fine-motion stage 12a based on the measurement result. The pins 13 are fixed to the coarse-motion stage 12b and hence move together with the coarse-motion stage 12b.

The processor 20 is a unit that forms a pattern on the substrate S held by the substrate holding unit 10. The processor 20 can include an irradiation optical system 21, an original stage 22, a projection optical system 23, and a detection unit 24.

The irradiation optical system 21 irradiates an original R held by the original stage 22 with light emitted from a light source (not shown). The original stage 22 can include an original chuck that holds the original R by vacuum suction or the like and an original driving mechanism that drives the original R by driving the original chuck. The original driving mechanism can, for example, translationally drive the original R in the X direction, the Y direction, and the Z direction and rotationally drive the original R in the θX direction, the θY direction, and the θZ direction. Driving in each direction can be controlled independently. The projection optical system 23 projects an image of the pattern on the original R irradiated with light by the irradiation optical system 21 onto the substrate S held by the substrate holding unit 10. In addition, the detection unit 24 is, for example, an off-axis scope and detects the alignment marks provided on the substrate S.

In this case, the position of the original stage 22 can be measured by a position measuring unit (not shown). The position measuring unit has, for example, a laser interferometer (not shown). In this case, the position measuring unit can measure the position of the original stage 22 by irradiating the original stage 22 with light and obtaining the displacement amount of the original stage 22 based on the light reflected by the original stage 22. Note that the position measuring unit of the original stage 22 may have an encoder instead of the laser interferometer.

The controller 30 is formed of a computer (information processing apparatus) including a processor such as a central processor unit (CPU) and a memory. The controller 30 comprehensively controls an exposure process by controlling each unit of the exposure apparatus 100. The controller 30 may be constituted by a PLD (the abbreviation of a Programmable Logic Device) such as an FPGA (the abbreviation of a Field Programmable Gate Array), an ASIC (the abbreviation of an Application Specific Integrated Circuit), a general purpose computer embedded with a program, or a combination of all or some of these components.

In addition, the controller 30 according to this embodiment includes an instruction unit 31, a memory unit 32, and an information processor 33. The instruction unit 31 controls each unit of the exposure apparatus 100. The memory unit 32 stores various types of information and data. The information processor 33 calculates the drive target positions of the substrate stage 12 and the original stage 22 and executes an exposure sequence and/or a supply/recovery sequence for the substrate S, which are recorded in the memory unit 32, in a predetermined sequence. Note that this embodiment has exemplified the case where the controller 30 includes the memory unit 32 and the information processor 33. However, the memory unit 32 and the information processor 33 may be provided separately from the controller 30.

The original conveying system 40 can include an original hand 41, an original pre-alignment stage 42, an original conveying robot 43, and a storage unit 44.

The original conveying robot 43 is an articulated robot. The original conveying robot 43 includes a hand that holds the original R and can move the hand to an arbitrary position in an XYZ space. The storage unit 44 is a base that stores the original R. The original R conveyed from outside the apparatus is placed on the storage unit 44. The original conveying robot 43, which is an articulated robot, places the original R placed on the storage unit 44 onto the original pre-alignment stage 42.

Observing a mark on the original R on the original pre-alignment stage 42 with a microscope (scope) will measure the positional relationship between the original R and the original pre-alignment stage 42. After the measurement, the original hand 41 holds the original R on the original pre-alignment stage 42 and moves to a position where the original R is transferred to the original stage 22. The original hand 41 transfers (conveys) the original R to the original stage 22 by moving in the -Z direction. The original stage 22 holds the original R by vacuum suction. It is possible to correct misalignments of the original R relative to the original pre-alignment stage 42 in the X direction, the Y direction, and the θZ direction in accordance with the position where the original hand 41 conveys the original R onto the original stage 22.

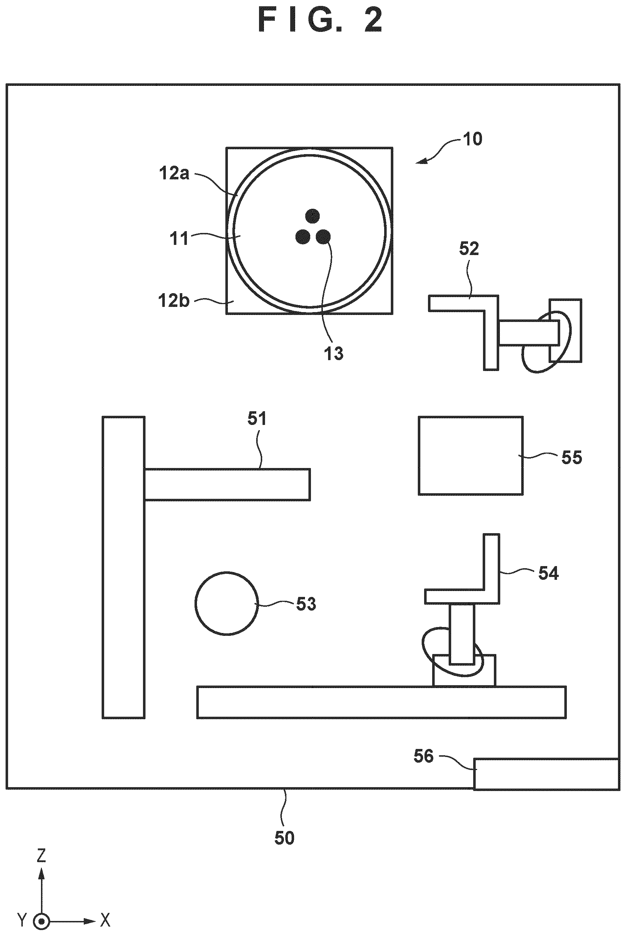

The substrate conveying system 50 can include the supply hand 51 (conveyance hand), the recovery hand 52, a pre-alignment unit 53, a conveying robot 54, a temporary base 55, and a storage unit 56. Fig. 2 is a schematic view showing an example of the arrangement of the substrate conveying system 50.

The substrate S is stored in the storage unit 56. The conveying robot 54 is an articulated robot. The conveying robot 54 includes a hand that holds the substrate S and can move the hand to an arbitrary position in an XYZ space. The conveying robot 54 retrieves the substrate S from the storage unit 56 and places the substrate S on the pre-alignment unit 53. The pre-alignment unit 53 measures the outer shape position of the substrate S relative to the pre-alignment unit 53 by irradiating a peripheral portion of the substrate S with measurement light and measuring reflected light from the peripheral portion with a sensor.

The supply hand 51 is a conveying mechanism for transferring (conveying) the substrate S from the pre-alignment unit 53 to the substrate holding unit 10. The supply hand 51 receives the substrate S from the pre-alignment unit 53, holds the substrate S by vacuum suction, and transfers (conveys) the substrate S onto the pins 13 protruding from the holding surface 11a of the substrate chuck 11 at the substrate holding unit 10.

The recovery hand 52 is a conveying mechanism for transferring (conveying) the substrate S from the substrate holding unit 10 to the temporary base 55. The recovery hand 52 receives the substrate S from the pins 13 protruding from the holding surface 11a of the substrate chuck 11 at the substrate holding unit 10, holds the substrate S by vacuum suction, and transfers (conveys) the substrate S to the temporary base 55. The temporary base 55 is a base on which the recovery hand 52 temporarily places the substrate S recovered from the substrate holding unit 10. The conveying robot 54 holds the substrate S placed on the temporary base 55 and conveys the substrate S to the storage unit 56 with the recovery hand 52.

The arrangement of the substrate holding unit 10 and a substrate holding process (substrate holding method) of causing the substrate chuck 11 to hold the substrate S will be described next. In this case, the substrate holding unit 10 (at least the substrate chuck 11 and the pins 13) and the controller 30 can constitute a substrate holding apparatus that holds the substrate S. The substrate processing method of processing a substrate using the exposure apparatus 100 (substrate processing apparatus) includes a holding step of causing the substrate chuck 11 to hold the substrate S by using the following substrate holding method and a processing step of causing the processor 20 to process the substrate S held by the substrate chuck 11 in the holding step.

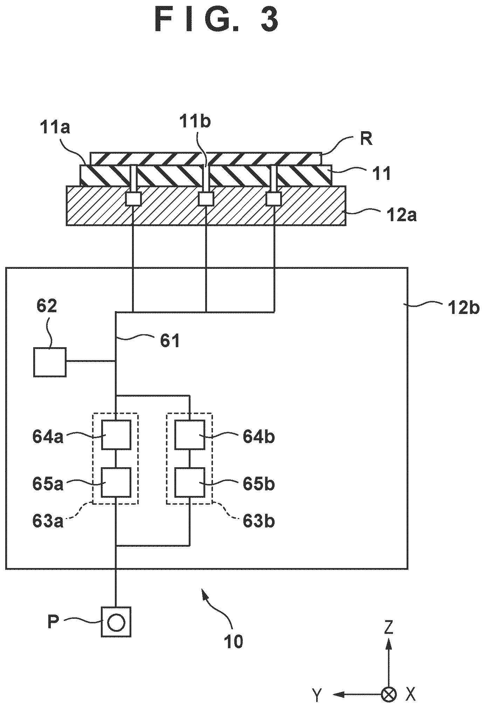

Fig. 3 is a schematic view showing an example of the arrangement of the substrate holding unit 10. The substrate chuck 11 is configured to hold the substrate S by vacuum suction. More specifically, the substrate chuck 11 is configured to hold the substrate S by exhausting gas from the space on substrate chuck 11 (that is, the space between the substrate chuck 11 and the substrate S placed on the pins 13 protruding from the holding surface 11a). The substrate chuck 11 is provided with the exhaust holes 11b for exhausting gas from the space on the substrate chuck. A pipe 61 is connected to each exhaust hole 11b. The fine-motion stage 12a holds the substrate chuck 11 by vacuum suction. The fine-motion stage 12a is placed on the coarse-motion stage 12b. The coarse-motion stage 12b is internally provided with a pressure sensor 62, a first exhaust system 63a, and a second exhaust system 63b. The first exhaust system 63a includes an electromagnetic valve 64a and a regulator 65a. The second exhaust system 63b includes an electromagnetic valve 64b and a regulator 65b.

The pipe 61 is connected to a vacuum pump P as a negative pressure generator. The vacuum pump P is placed outside the coarse-motion stage 12b and can be configured as, for example, factory equipment. The pressure sensor 62 monitors (detects) the internal pressure of the pipe 61. The pressure sensor 62 is placed to detect the internal pressure of the pipe 61 between the portion where the pipe 61 branches to the respective exhaust holes 11b of the substrate chuck 11 and the electromagnetic valves 64a and 64b of the exhaust systems 63a and 63b. The pressure sensor 62 may be understood as a sensor that detects the pressure of the space on the substrate chuck 11.

The first exhaust system 63a (the electromagnetic valve 64a and the regulator 65a) and the second exhaust system 63b (the electromagnetic valve 64b and the regulator 65b) are arranged in parallel on the pipe 61 between the vacuum pump P and the substrate chuck 11 (the exhaust hole 11b). In the first exhaust system 63a, the regulator 65a is a mechanism for regulating the internal pressure of the pipe 61 to a desired vacuum pressure (exhaust pressure) and is configured to arbitrarily set (change) the desired vacuum pressure. The electromagnetic valve 64a is placed closer to the substrate chuck 11 than the regulator 65a and is controlled by the controller 30. The electromagnetic valve 64a is ON/OFF-controlled to switch whether to supply the vacuum pressure regulated by the regulator 65a to the substrate chuck 11 (the exhaust hole 11b). More specifically, when the electromagnetic valve 64a is turned on, the vacuum pressure regulated by the regulator 65a is supplied to the substrate chuck 11 (the exhaust hole 11b). In contrast to this, when the electromagnetic valve 64a is turned off, the vacuum pressure regulated by the regulator 65a is not supplied to the substrate chuck 11 (the exhaust hole 11b). The arrangements of the electromagnetic valve 64b and the regulator 65b in the second exhaust system 63b are the same as those of the electromagnetic valve 64a and the regulator 65a in the first exhaust system 63a.

In the first exhaust system 63a and the second exhaust system 63b, the regulators 65a and 65b may regulate the internal pressures to the same or different vacuum pressures. For example, the regulator 65b of the second exhaust system 63b may regulate the internal pressure to a vacuum pressure lower than the vacuum pressure to which the regulator 65a of the first exhaust system 63a regulates the internal pressure. That is, the second exhaust system 63b may be configured (set) such that the exhaust performance through the exhaust hole 11b becomes smaller than that through the first exhaust system 63a.

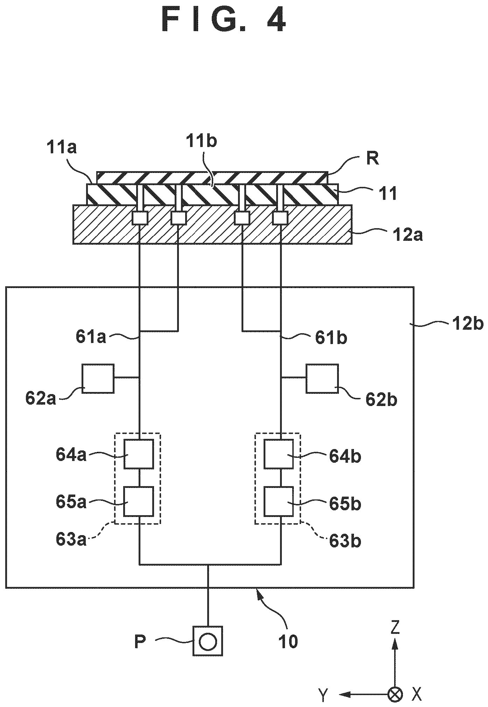

In this case, the substrate holding unit 10 in Fig. 3 is configured such that the first exhaust system 63a and the second exhaust system 63b are connected to the substrate chuck 11 via the common pipe 61 (one-system pipe arrangement). However, limitation is not made thereto. For example, as shown in Fig. 4, the substrate holding unit 10 may be configured such that the first exhaust system 63a and the second exhaust system 63b are connected to the substrate chuck 11 via the different pipes 61a and 61b (two-system pipe arrangement). More specifically, in the substrate holding unit 10 in Fig. 4, the first exhaust system 63a including the electromagnetic valve 64a and the regulator 65a is placed on the pipe 61a, and the second exhaust system 63b including the electromagnetic valve 64b and the regulator 65b is placed on the pipe 61b. The pipes 61a and 61b are connected to the vacuum pump P. A pressure sensor 62a monitors (detects) the internal pressure of the pipe 61a. A pressure sensor 62b monitors (detects) the internal pressure of the pipe 61b.

In the arrangements in Figs. 3 and 4, when the electromagnetic valve 64b is turned off by turning on the electromagnetic valve 64a, only the vacuum pressure regulated by the regulator 65a of the first exhaust system 63a is supplied to the substrate chuck 11 (the exhaust hole 11b) via the pipe 61 (61a). In contrast to this, when the electromagnetic valve 64b is turned on by turning off the electromagnetic valve 64a, only the vacuum pressure regulated by the regulator 65b of the second exhaust system 63b is supplied to the substrate chuck 11 (the exhaust hole 11b) via the pipe 61 (61b). That is, according to the arrangements in Figs. 3 and 4, only turning on/off the electromagnetic valves 64a an 64b makes it possible to switch quickly (at high speed) the exhaust pressures when exhaust is performed through the exhaust hole 11b.

Figs. 3 and 4 show an arrangement including the two exhaust systems 63a and 63b. However, the present disclosure is not limited to this and may have an arrangement including three or more exhaust systems. In addition, each exhaust system is constituted by a combination of an electromagnetic valve and a regulator. However, the present disclosure is not limited to this and may use a servo valve whose opening degree can be arbitrarily set or may use a proportional electromagnetic valve that can be controlled in proportion to a current. Obviously, a combination of them may be used. For example, one of a plurality of exhaust systems may have an arrangement using a combination of an electromagnetic valve and a regulator, and the other may have an arrangement using a servo valve or proportional electromagnetic valve. Combining these elements can increase the degree of freedom in vacuum pressure (exhaust pressure) to be set.

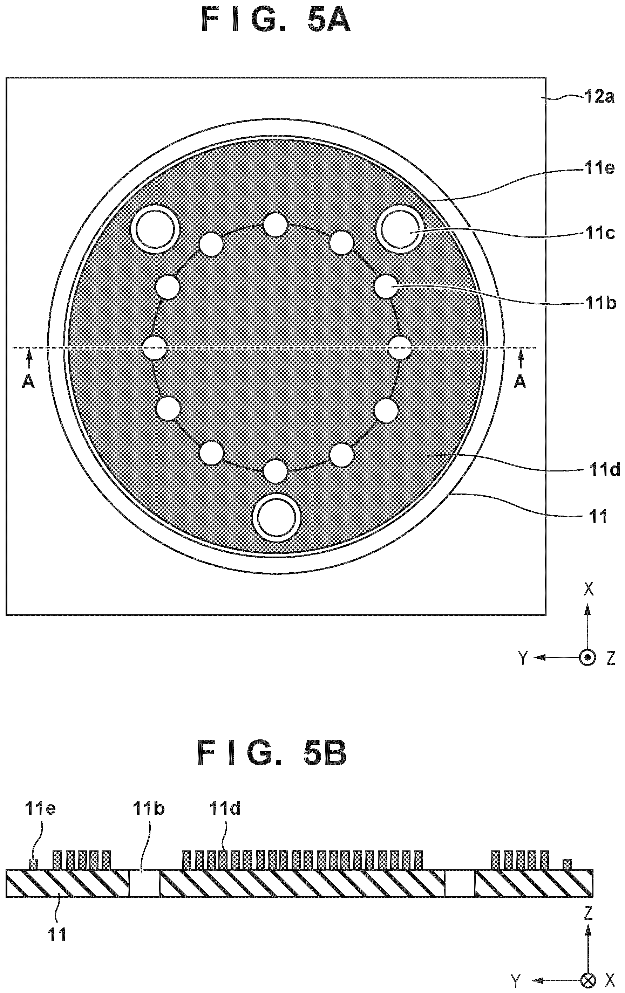

Figs. 5A and 5B are schematic views showing an example of the arrangement of the substrate chuck 11. Fig. 5A shows a view of the substrate chuck 11 seen from the +Z direction. Fig. 5B is a sectional view of the substrate chuck 11 taken along A - A in Fig. 5A.

The substrate chuck 11 has exhaust holes 11b through which gas is exhausted from the space on the substrate chuck 11 to hold the substrate S by vacuum suction, and openings 11c through which the pins 13 protrude. In the case shown in Figs. 5A and 5B, the 12 exhaust holes 11b are arranged perimetrically. However, the number and placement of exhaust holes 11b are not limited to those shown in Figs. 5A and 5B. The number and placement of openings 11c are not limited to the example in Figs. 5A and 5B, but can also be properly set in accordance with the number and placement of pins 13.

The substrate chuck 11 is provided with a plurality of support pins 11d and a seal portion 11e. The plurality of support pins 11d are projections for supporting the substrate S, and the substrate S is placed on the upper surfaces of the plurality of support pins 11d. The upper surfaces of the plurality of support pins 11d may be understood as the holding surface 11a of the substrate chuck 11. The seal portion 11e is a member for maintaining the vacuum pressure between the substrate S and the substrate chuck 11 by reducing the intrusion of an external gas (atmospheric air) in a state in which the substrate S is placed on the plurality of support pins 11d (that is, a state in which the substrate S is held by the substrate chuck 11). The seal portion 11e is formed in an annular shape along the peripheral portion of the substrate S placed on the plurality of support pins 11d and is configured such that the level of the upper surface of the seal portion 11e is lower than that of the upper surfaces of the plurality of support pins 11d. Note that the substrate chuck 11 may be configured so as not to be provided with the seal portion 11e or configured to be provided with a plurality of seal portions 11e. That is, the presence/absence, number, and placement of the seal portions 11e are not limited to those in the example shown in Fig. 5A and 5B.

When the substrate chuck 11 having the above arrangement holds the substrate S, the first exhaust system 63a or the second exhaust system 63b performs exhaust through the exhaust holes 11b to form a vacuum between the plurality of support pins 11d. This enables the substrate chuck 11 to hold the substrate S with uniform force throughout the substrate S. In addition, it is possible to reduce the intrusion of a gas from the outside to between the substrate S and the substrate chuck 11 by the seal portion 11e. The vacuum pressure between the substrate S and the substrate chuck 11 can be maintained. Note that since the upper surfaces of the plurality of support pins 11d are higher than the upper surface of the seal portion 11e, the seal portion 11e and the substrate S do not come into contact with each other in a case where the substrate S is held by the substrate chuck 11.

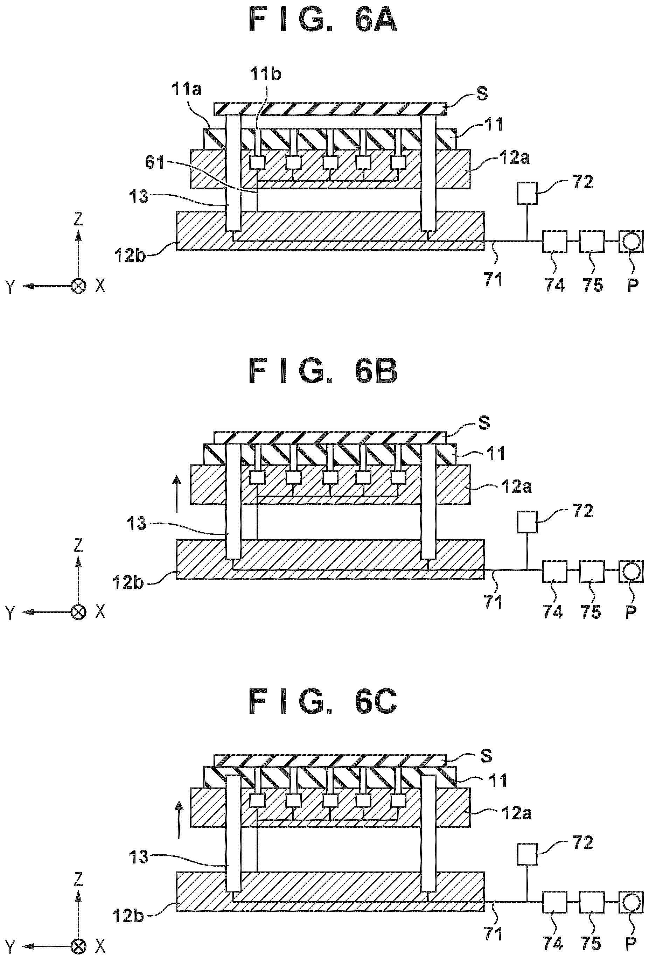

Figs. 6A to 6C are views for explaining a substrate holding process of causing the substrate chuck 11 to hold the substrate S. The substrate holding process includes a substrate mounting process (substrate mounting step) of mounting the substrate S on the substrate chuck 11 by placing the substrate S on the pins 13 protruding from the holding surface 11a of the substrate chuck 11 and then reducing the protrusion amount of the pins 13 from the holding surface 11a. Figs. 6A to 6C show the substrate mounting process in chronological order. Note that the controller 30 can control the substrate holding process.

In this case, the pin 13 has an exhaust hole in its distal end. The exhaust hole is connected to the vacuum pump P via a pipe 71. An electromagnetic valve 74 and a regulator 75 are arranged on the pipe 71 between the vacuum pump P and the pin 13. The regulator 75 is configured to be able to regulate the internal pressure to a desired vacuum pressure. The electromagnetic valve 74 is placed closer to the pins 13 than the regulator 75. The controller 30 performs ON/OFF control to switch whether to supply the vacuum pressure regulated by the regulator 65a to the pins 13. When the electromagnetic valve 74 is turned on, the vacuum pressure regulated by the regulator 75 is supplied to the pins 13. In contrast to this, when the electromagnetic valve 74 is turned off, the vacuum pressure regulated by the regulator 75 is not supplied to the pins 13. In addition, a pressure sensor 72 that monitors (detects) the internal pressure of the pipe 71 is provided to monitor the pressure between the pins 13 and the substrate S. The pressure sensor 72 is placed to detect the internal pressure of the pipe 71 located closer to the pins 13 than the electromagnetic valve 74. Referring to Figs. 6A to 6C, the pressure sensor 72, the electromagnetic valve 74, and the regulator 75 are arranged outside the coarse-motion stage 12b. However, limitation is not made thereto. These components may be arranged in the coarse-motion stage 12b.

Fig. 6A shows a state in which the pins 13 protrude from the holding surface 11a of the substrate chuck 11 upon driving of the fine-motion stage 12a in the -Z direction. When the substrate S is placed (conveyed) on the pins 13 by the substrate conveying system 50, the controller 30 causes the pins 13 to hold the substrate S by turning on the electromagnetic valve 74. The controller 30 drives the fine-motion stage 12a in the +Z direction to reduce the protrusion amount of the pins 13 from the holding surface 11a.

Figs. 6A to 6C show a state in which the protrusion amount of the pins 13 from the holding surface 11a is reduced by driving the fine-motion stage 12a in the +Z direction. As shown in Fig. 6B, as the fine-motion stage 12a is driven in the +Z direction, the upper surfaces of the pins 13 become level with the holding surface 11a of the substrate chuck 11, and the substrate S and the substrate chuck 11 start to come into contact with each other. At this time, the controller 30 turns off the electromagnetic valve 74 to release the holding of the substrate S by the pins 13. As shown in Fig. 6C, as the fine-motion stage 12a is further driven in the +Z direction, the upper surfaces of the pins 13 become lower in level than the holding surface 11a of the substrate chuck 11, and the pins 13 are stored in the substrate chuck 11. This makes it possible to mount the substrate S on the holding surface 11a of the substrate chuck 11. In this case, the fine-motion stage 12a can move in the Z direction while tilting in accordance with the positional relationship with the three pins 13 in the Z direction. The pins 13 are fixed to the coarse-motion stage 12b that can move in the X and Y directions. The relative position between the fine-motion stage 12a and the coarse-motion stage 12b in the Z direction, that is, the protrusion amount of the pins 13 from the holding surface 11a, can be measured by a sensor such as an interferometer, electrostatic capacitance sensor, or encoder.

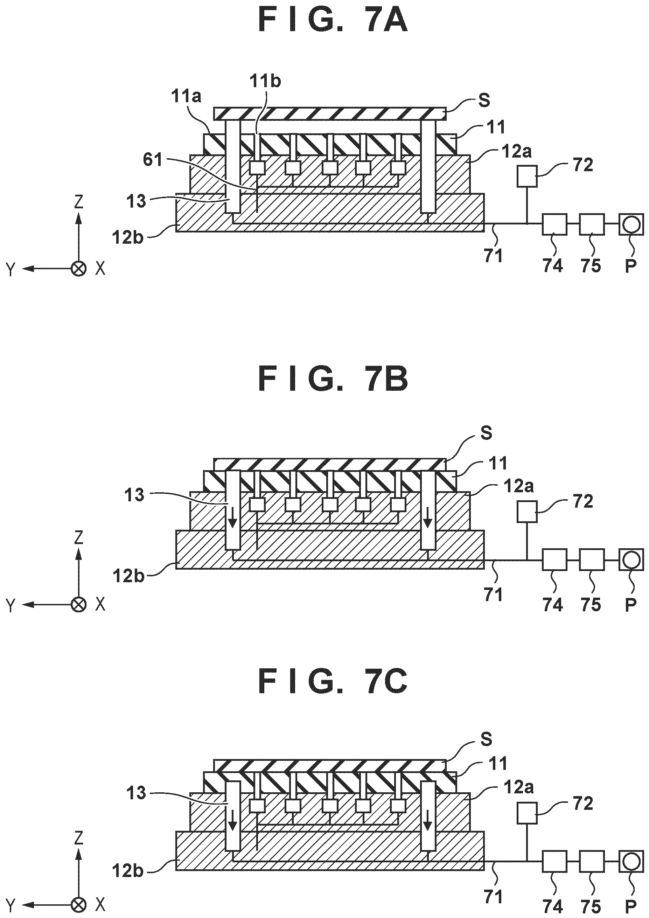

Figs. 6A to 6C show a case where the substrate S is mounted on the substrate chuck 11 by driving the fine-motion stage 12a relative to the coarse-motion stage 12b. The substrate S may be mounted on the substrate chuck 11 by only changing the relative position between the substrate chuck 11 and the pins 13 in the Z direction. For example, as shown in Figs. 7A to 7C, the present disclosure may use an arrangement that drives the pins 13 (the entirety or distal end portions thereof) relative to the substrate chuck 11 (the fine-motion stage 12a) in the Z direction. Figs. 7A to 7C show an example of performing a substrate mounting process by driving the pins 13 relative to the substrate chuck 11 in the - Z direction in chronological order. The relative position between the substrate chuck 11 and the pins 13 in the Z direction is changed by a driving mechanism that relatively drives the substrate chuck 11 and the pins 13 in the Z direction. Note that in the following description, to drive the distal end portions of the pins 13 relative to the substrate chuck 11 will be sometimes expressed as "to drive the pins 13".

Fig. 7A shows a state in which the pins 13 protrude from the holding surface 11a of the substrate chuck 11 upon driving of the pins 13 in the +Z direction. When the substrate S is placed (conveyed) on the pins 13 by the substrate conveying system 50, the controller 30 turns on the electromagnetic valve 74 to cause the pins 13 to hold the substrate S. The controller 30 reduces the protrusion amount of the pins 13 from the holding surface 11a by driving the pins 13 in -Z direction. As the pins 13 are driven in the -Z direction, the upper surfaces of the pins 13 become level with the holding surface 11a of the substrate chuck 11, and the substrate S starts to come into contact with the substrate chuck 11, as shown in Fig. 7B. At this time, the controller 30 turns off the electromagnetic valve 74 to release the holding of the substrate S by the pins 13. As the pins 13 are further driven in the -Z direction, the upper surfaces of the pins 13 become lower in level than the holding surface 11a of the substrate chuck 11, and the pins 13 are stored in the substrate chuck 11, as shown in Fig. 7C. This makes it possible to mount the substrate S on the holding surface 11a of the substrate chuck 11. Although Figs. 7A to 7C shows an example of driving the distal end portions of the pins 13 in the -Z direction, the entirety of the pins 13 may be driven in the -Z direction. In addition, the driving mechanism for driving each pin 13 may be provided on the pin 13 itself or may be provided outside the pin 13 (for example, on the coarse-motion stage 12b).

In a substrate mounting process, in reducing the protrusion amount of the pins 13 from the holding surface 11a of the substrate chuck 11, the higher the relative speed between the substrate chuck 11 and the pins 13 in the Z direction, the better in terms of the throughput (productivity) of the exposure apparatus 100. However, as the relative speed between the substrate chuck 11 and the pins 13 in the Z direction increases, the gap between the holding surface 11a of the substrate chuck 11 and the substrate S narrows faster, and the atmospheric pressure of the space between the holding surface 11a and the substrate S increases. In this case, since the wind pressure against the substrate S increases due to an increase in the atmospheric pressure of the space, the substrate S sometimes sideslips (shifts) on the pins 13. If the substrate S sideslips on the pins, dropping off of the substrate S from the pins 13 or wearing of the pins 13 sometimes occurs. When the substrate S is mounted on the substrate chuck 11, the plurality of support pins 11d on the substrate chuck 11 sometimes wear. For this reason, exhaust may be performed through the exhaust holes 11b of the substrate chuck 11 in the period (interval) from when the protrusion amount of the pins 13 from the holding surface 11a starts to decrease until when the holding surface 11a and the substrate S start to come into contact with each other. At this time, an exhaust pressure is preferably set to reduce the sideslipping of the substrate S on the pins 13.

In contrast, if exhaust is performed through the exhaust holes 11b with an exhaust pressure that can reduce the sideslipping of the substrate S on the pins 13, distortion is generated in the substrate S when the holding surface 11a of the substrate chuck 11 starts to come into contact with the substrate S. That is, the substrate S is held by the substrate chuck 11 in a state where the distortion is generated in the substrate S. In addition, a large frictional force is generated on the contact surface between the holding surface 11a and the substrate S. This may cause friction of the substrate chuck 11. Accordingly, when the holding surface 11a of the substrate chuck 11 starts to come into contact with the substrate S, the exhaust pressure is preferably reduced.

Accordingly, the substrate mounting process according to this embodiment includes a first exhaust operation and a second exhaust operation to be performed after the first exhaust operation. The first exhaust operation is an exhaust operation of exhausting gas from the space on the substrate chuck 11 through the exhaust holes 11b with the first set value of exhaust pressure (a first exhaust pressure). The second exhaust operation is an exhaust operation of exhausting gas from the space on the substrate chuck 11 through the exhaust holes 11b with the second set value of exhaust pressure (a second exhaust pressure) smaller than the first set value. Switching from the first exhaust operation to the second exhaust operation is performed in the period from when the protrusion amount of the pins 13 from the holding surface 11a of the substrate chuck 11 start to decrease until when the holding surface 11a and the substrate S start to come into contact with each other. This makes it possible to simultaneously achieve a reduction in the distortion of the substrate S at the time of holding the substrate S on the substrate chuck 11 and an improvement in throughput.

A substrate mounting process includes a state in which there is a gap between the substrate chuck 11 and the substrate S and a state in which the substrate chuck 11 is in contact with the substrate S. Switching from the first exhaust operation to the second exhaust operation in this embodiment is performed at a timing when or before the substrate chuck 11 and the substrate S start to come into contact with each other. In addition, an exhaust pressure is a pressure with which gas is exhausted (inspired) from the space on the substrate chuck 11 through the exhaust holes 11b, and may be understood as the flow rate or flow velocity of a gas exhausted from the space through the exhaust holes 11b. An exhaust pressure is determined by the value (the flow rate or flow velocity) set by the regulator 65a of the first exhaust system 63a and the regulator 65b of the second exhaust system 63b.

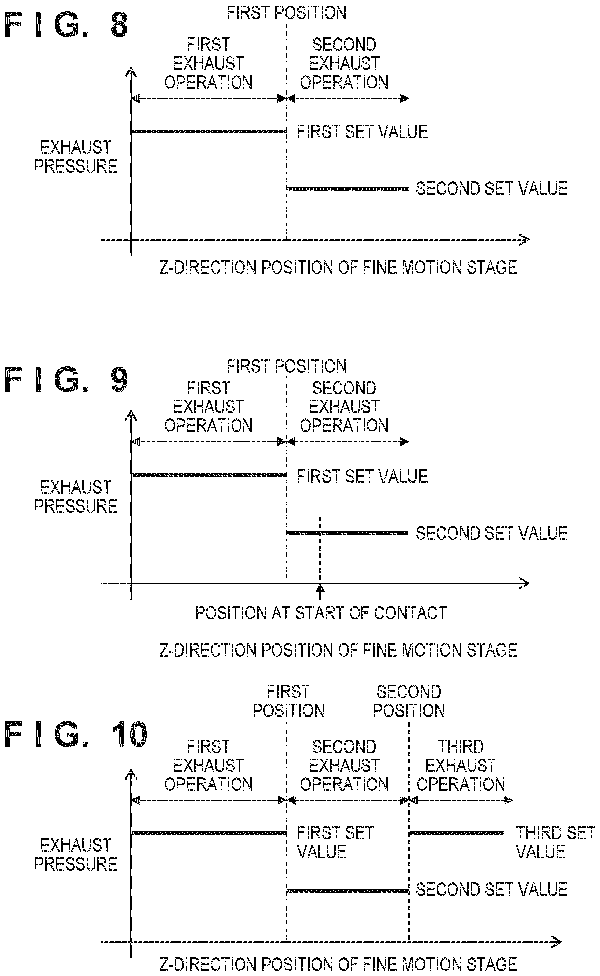

Fig. 8 shows an example of the first exhaust operation and the second exhaust operation in a substrate mounting process. Referring to Fig. 8, the Z-direction position of the fine-motion stage 12a is represented by the abscissa, and the exhaust pressure is represented by the ordinate. Referring to Fig. 8, "the Z-direction position of the fine-motion stage 12a" represented by the abscissa may be understood as the position of the holding surface 11a of the substrate chuck 11 in the Z direction. In addition, the abscissa in Fig. 8 may be understood as the protrusion amount of the pins 13 from the holding surface 11a of the substrate chuck 11 in the Z direction, or the gap between the holding surface 11a and the substrate S.

In a substrate mounting process, the first exhaust operation is started at the start of driving the fine-motion stage 12a in the +Z direction, that is, reducing the protrusion amount of the pins 13 from the holding surface 11a. In the first exhaust operation, exhaust is performed with the first set value of exhaust pressure so as to reduce the sideslipping of the substrate S on the pins 13 due to the wind pressure generated upon movement of the fine-motion stage 12a at a high speed. The first set value is set to a value that can make the sideslipping amount (shift amount) of the substrate S on the pins 13 fall within an allowable range in the period from when the protrusion amount of the pins 13 starts to decrease until when the holding surface 11a of the substrate chuck 11 and the substrate S start to come into contact with each other. This makes it possible to reduce the sideslipping of the substrate S on the pins 13.

The exhaust amount in the first exhaust operation (the flow rate of gas exhausted through the exhaust holes 11b) is preferably equal to or higher than the flow rate of gas extruded from the space on the substrate chuck 11 upon driving of the fine-motion stage 12a in the +Z direction (to be sometimes referred to as a gas extrusion amount hereinafter). Note, however, that it may be difficult to make the exhaust amount in the first exhaust operation be equal to or larger than the gas extrusion amount depending on the placement of a pipe system in the apparatus. In this case, the exhaust amount in the first exhaust operation is preferably set in consideration of the holding of the substrate S by the pins 13. For example, since the substrate S is sucked by the pins 13 by vacuum suction, it is possible to reduce the sideslipping of the substrate S on the pins 13 as long as the exhaust amount in the first exhaust operation is equal to or larger than the value obtained by subtracting the vacuum suction amount of the substrate S by the pins 13 from the gas extrusion amount.

The second exhaust operation is started at the timing when the Z-direction position of the fine-motion stage 12a reaches the first position. That is, the first exhaust operation is switched to the second exhaust operation at this timing. In the second exhaust operation, exhaust is performed with the second set value of exhaust pressure smaller than the first set value so as to reduce the distortion of the substrate S caused by the holding of the substrate S by the substrate chuck 11. The second set value is set to a value that can make the distortion amount of the substrate S caused by the holding of the substrate S by the substrate chuck 11 fall within an allowable range. This makes it possible to reduce the distortion of the substrate S caused by the holding of the substrate S by the substrate chuck 11. In addition, providing the second exhaust operation makes it possible to reduce the frictional force between the holding surface 11a of the substrate chuck 11 and the substrate S and reduce the wear of the substrate chuck 11.

The first position is defined as the Z-direction position of the fine-motion stage 12a when the holding surface 11a and the substrate S start to come into contact with each other, or a position closer to the -Z-direction side than such the Z-direction position. This position is obtained in advance by experiments, simulations, or the like and stored in the controller 30 (the memory unit 32). In the case in Fig. 8, the first position is defined as the Z-direction position of the fine-motion stage 12a when the holding surface 11a and the substrate S start to come into contact with each other.

In this case, Fig. 8 shows a case where the fine-motion stage 12a is driven in the +Z direction in a substrate mounting process. The same operation is preformed even in a case where the pins 13 are driven in the -Z direction. Since the case of driving the fine-motion stage 12a is opposite in only driving direction to the case of driving the pins 13, the operation in Fig. 8 can be applied to the latter case by replacing the +Z direction in Fig. 8 with the -Z direction. The drawings and description given below indicate the case of driving the fine-motion stage 12a. However, when the pins 13 are to be driven, the above operation may be applied upon relacing the +Z direction with the -Z direction. In this case, in the description of Fig. 8 and the drawings to be described later, the driving of the fine-motion stage 12a can be regarded as the movement of the substrate chuck 11 and may be replaced with the driving of the pins 13 or the relative driving between the fine-motion stage 12a and the pins 13.

The exhaust pressure through the exhaust holes 11b can be determined based on the speed of the fine-motion stage 12a, the suction holding force of the substrate S with the pins 13, and/or the characteristics of the substrate S. The speed of the fine-motion stage 12a tends to increase in consideration of throughput. When the fine-motion stage 12a is to be driven at a high speed, a high exhaust pressure may be set in the first exhaust operation. The suction holding force based on the pins 13 is a vacuum pressure with which the pins 13 hold the substrate S by vacuum suction. If the vacuum pressure is low, the substrate S may sideslip on the pins 13 due to the wind pressure generated during the driving of the fine-motion stage 12a. Accordingly, a high exhaust pressure is preferably set in the first exhaust operation. The characteristics of the substrate S include the warpage amount, the roughness of the reverse surface, and the type, material, and/or thickness of a film. An exhaust pressure in the second exhaust operation may be properly set in accordance with the characteristics of the substrate S. If warpage has occurred in the substrate S, a high exhaust pressure may be set in the second exhaust operation. Note that an exhaust pressure may be set in the second exhaust operation in consideration of also the characteristics of the substrate chuck 11. The characteristics of the substrate chuck 11 can include the height uniformity of the plurality of support pins 11d and/or the presence/absence of the seal portion 11e. If, for example, the holding surface 11a of the substrate chuck 11 is not provided with the seal portion 11e, since the inflow of atmospheric air from the surroundings increases, a high exhaust pressure is preferably set in the second exhaust operation.

The substrate mounting process according to this embodiment has exemplified the case where switching from the first exhaust operation to the second exhaust operation is performed while the fine-motion stage 12a is moved. However, limitation is not made thereto. For example, the first exhaust operation may be performed while the fine-motion stage 12a is moved, the movement of the fine-motion stage 12a may be temporarily stopped at the timing when the Z-direction position of the fine-motion stage 12a reaches the first position, and the first exhaust operation may be switched to the second exhaust operation in this state. That is, switching from the first exhaust operation to the second exhaust operation may be performed while reduction in the protrusion amount of the pins 13 from the holding surface 11a of the substrate chuck 11 is temporarily stopped. In a substrate mounting process, it is possible to freely change the moving speed of the fine-motion stage 12a or temporarily stopping the movement. The movement of the fine-motion stage 12a can be temporarily stopped before the holding surface 11a of the substrate chuck 11 and the substrate S start to come into contact with each other. By performing this temporary stopping operation before the substrate chuck 11 and the substrate S start to come into contact with each other, it is possible to more reliably reduce the distortion of the substrate S caused by the holding of the substrate S by the substrate chuck 11.

Note that the moving speed and movement pattern of the fine-motion stage 12a can be freely set. It is possible to reduce the sideslipping of the substrate S on the pins 13 and reduce the distortion of the substrate S caused when the substrate chuck 11 and the substrate S start to come into contact with each other, either in a case where temporary stopping is performed or a case where temporary stopping is not performed. In addition, in this embodiment, the exhaust pressure is switched in two steps in the first exhaust operation and the second exhaust operation. However, the number of steps in which the exhaust pressure is switched is not limited to two and may be three or more. And, this embodiment describes an example in which the exhaust pressure is changed stepwise (discretely). However, the exhaust pressure may be changed continuously. That is, the exhaust pressure may be gradually changed from the first exhaust pressure (the first set value) to the second exhaust pressure (the second set value). The continuous change of the exhaust pressure may be performed, for example, based on a graph or table indicating a relationship between an exhaust pressure and time determined in advance, or based on a specific function.

A method of switching from the first exhaust operation to the second exhaust operation in a substrate mounting process will be described next. As described above with reference to Figs. 3 and 4, the substrate holding apparatus according to this embodiment is provided with the first exhaust system 63a including the electromagnetic valve 64a and the regulator 65a and the second exhaust system 63b including the electromagnetic valve 64b and the regulator 65b.

For example, the first exhaust operation is performed while both the electromagnetic valve 64a of the first exhaust system 63a and the electromagnetic valve 64b of the second exhaust system 63b are ON. The second exhaust operation is then performed while the electromagnetic valve 64b of the second exhaust system 63b is turned off and the electromagnetic valve 64a of the first exhaust system 63a is turned on at the timing when the Z-direction position of the fine-motion stage 12a reaches the first position. Alternatively, the second exhaust operation is performed while the electromagnetic valve 64a of the first exhaust system 63a is turned off and only the electromagnetic valve 64b of the second exhaust system 63b is turned on at this timing. This makes it possible to reduce the set value (second set value) of exhaust pressure in the second exhaust operation to a value smaller than the set value (first set value) of exhaust pressure in the first exhaust operation. As described above, turning off one of the two electromagnetic valves 64a and 64b in the ON state in this manner can smoothly switch from the first exhaust operation to the second exhaust operation.

A vacuum pressure is set in each of the regulators 65a and 65b in accordance with the first and second set values. If, for example, the second set value of exhaust pressure is reduced to about half of the first set value of exhaust pressure, the same exhaust pressure can be set in each of the regulators 65a and 65b or set in consideration of the length of the pipe 61. If consideration is to be given to the length of the pipe 61, vacuum pressure setting in each of the regulators 65a and 65b is performed by comparing the exhaust pressure set when the electromagnetic valves 64a and 64b are turned on with the exhaust pressure set when the electromagnetic valve 64a is turned on and the electromagnetic valve 64b is turned off. In this manner, the first and second set values can be determined in accordance with the exhaust pressure required for each exhaust operation.

In addition, if the vacuum pressure regulated by the regulator 65b of the second exhaust system 63b is lower than the vacuum pressure regulated by the regulator 65a of the first exhaust system 63a, the exhaust systems used for the first exhaust operation and the second exhaust operation may be switched. More specifically, the first exhaust operation is performed while the electromagnetic valve 64a of the first exhaust system 63a is ON and the electromagnetic valve 64b of the second exhaust system 63b is OFF. That is, the first exhaust operation is performed by using only the first exhaust system 63a. The second exhaust operation is performed at the timing when the Z-direction position of the fine-motion stage 12a reaches the first position while the electromagnetic valve 64a of the first exhaust system 63a is OFF and the electromagnetic valve 64b of the second exhaust system 63b is ON. That is, the second exhaust operation is performed by using only the second exhaust system 63b.

As described above, exhaust pressures are set in combination of the electromagnetic valves 64a and 64b and the regulators 65a and 65b. However, the same applies to a case where servo valves and proportional electromagnetic valves are used instead of the above components. Servo valves and proportional electromagnetic valves allow arbitrary setting of opening degrees, and hence it is possible to simplify the constituent elements of the apparatus by reducing the number of pipe systems. In addition, the arrangement in Fig. 3 may use servo valves instead of the electromagnetic valve 64b and regulator 65b. In this case, it is possible to advantageously change the opening degrees of the servo valves in accordance with the characteristics of the substrate S such as the warpage amount of the substrate S.

As described above, in the substrate holding process (substrate mounting process) according to this embodiment, the first exhaust operation is switched to the second exhaust operation in the period from when the protrusion amount of the pins 13 from the holding surface 11a of the substrate chuck 11 starts to decrease until when the holding surface 11a and the substrate S start to come into contact with each other. Since the sideslipping of the substrate S on the pins 13 is reduced by the first exhaust operation, a substrate mounting process can be performed without reducing the decrease rate of the protrusion amount of the pins 13 from the holding surface 11a of the substrate chuck 11. This can be advantageous in throughput. The second exhaust operation can then reduce the distortion of the substrate S caused when the substrate S comes into contact with the holding surface 11a of the substrate chuck 11. In addition, the first exhaust operation is switched to the second exhaust operation at a timing when or before the holding surface 11a and the substrate S start to come into contact with each other. This can be advantageous in throughput. That is, the substrate mounting process according to this embodiment is advantageous in the distortion of the substrate S and throughput in a substrate holding process.

### [Modification]

In the case in Fig. 8 described above, the first position is the Z-direction position of the fine-motion stage 12a when the holding surface 11a and the substrate S start to come into contact with each other. Note, however, that the first position can be the Z-direction position of the fine-motion stage 12a before the holding surface 11a and the substrate S start to come into contact with each other (for example, immediately before the holding surface 11a and the substrate S start to come into contact with each other).

Fig. 9 shows a modification of the first exhaust operation and the second exhaust operation in a substrate mounting process. In the case in Fig. 9, the first position is defined as the Z-direction position of the fine-motion stage 12a immediately before the holding surface 11a and the substrate S start to come into contact with each other, and the Z-direction position of the fine-motion stage 12a when the holding surface 11a and the substrate S start to come into contact with each other is indicated after the first position. That is, in the case in Fig. 9, the first exhaust operation is switched to the second exhaust operation at a timing before the holding surface 11a of the substrate chuck 11 and the substrate S start to come into contact with each other. With this operation, the first exhaust operation is switched to the second exhaust operation in a state where a gap exists between the substrate chuck 11 and the substrate S, and hence the distortion of the substrate S caused by the holding of the substrate S by the substrate chuck 11 can be reliably reduced.

### <Second Embodiment>

The second embodiment of the present disclosure will be described. The first embodiment has exemplified the case where the exhaust pressure is switched in two steps in the first exhaust operation and the second exhaust operation in a substrate mounting process. In this embodiment, the third exhaust operation is further performed after the second exhaust operation, and the exhaust pressure is switched in three steps in a substrate mounting process. Note that this embodiment basically inherits the first embodiment and can follow the first embodiment except for matters referred to below.

Fig. 10 shows an example of an exhaust operation in the substrate mounting process according to this embodiment. Referring to Fig. 10, the Z-direction position of a fine-motion stage 12a is represented by the abscissa, and the exhaust pressure is represented by the ordinate. The substrate mounting process according to this embodiment further includes a third exhaust operation of exhausting gas from the space on a substrate chuck 11 with the third set value of exhaust pressure (third exhaust pressure) larger than the second set value after the second exhaust operation.

As shown in Fig. 10, in the substrate mounting process according to this embodiment, when driving of the fine-motion stage 12a in the +Z direction, that is, reduction in the protrusion amount of pins 13 from a holding surface 11a, is started, the first exhaust operation of performing exhaust with the first set value of vacuum pressure is started. The second exhaust operation of performing exhaust with the exhaust pressure as the second set value smaller than the first set value is started at the timing when the Z-direction position of the fine-motion stage 12a reaches the first position. That is, the first exhaust operation is switched to the second exhaust operation at this timing. The first position can be defined as the Z-direction position of the fine-motion stage 12a when the holding surface 11a and a substrate S start to come into contact with each other.

In the substrate mounting process according to this embodiment, the third exhaust operation of performing exhaust with the third set value of exhaust pressure larger than the second set value is started at the timing when the Z-direction position of the fine-motion stage 12a reaches the second position. That is, the second exhaust operation is switched to the third exhaust operation at this timing. The third set value is a set value of exhaust pressure for holding the substrate S by the substrate chuck 11 by vacuum suction and can be set to a value larger than the second set value. In this embodiment, the third set value is equal to the first set value but can be equal to or smaller than the first set value (that is, the third exhaust pressure can be equal to or smaller than the first exhaust pressure). The second position is defined as the Z-direction position of the fine-motion stage 12a after the holding surface 11a and the substrate S start to come into contact with each other, and determined in advance and stored in a memory unit 32. The third exhaust operation can shorten the time taken to hold the substrate S by the substrate chuck 11 by forming a vacuum between the substrate chuck 11 and the substrate S and hence is advantageous in throughput.

A method of switching exhaust operations in a substrate mounting process will be described next. As described above with reference to Figs. 3 and 4, the substrate holding apparatus according to this embodiment is provided with a first exhaust system 63a including an electromagnetic valve 64a and a regulator 65a and a second exhaust system 63b including an electromagnetic valve 64b and a regulator 65b.

For example, the first exhaust operation is performed while both the electromagnetic valve 64a of the first exhaust system 63a and the electromagnetic valve 64b of the second exhaust system 63b are ON. The second exhaust operation is then performed while the electromagnetic valve 64b of the second exhaust system 63b is turned off and the electromagnetic valve 64a of the first exhaust system 63a is turned on at the timing when the Z-direction position of the fine-motion stage 12a reaches the first position. Alternatively, the second exhaust operation is performed while the electromagnetic valve 64a of the first exhaust system 63a is turned off and only the electromagnetic valve 64b of the second exhaust system 63b is turned on at this timing. This makes it possible to reduce the set value (second set value) of exhaust pressure in the second exhaust operation to a value smaller than the set value (first set value) of exhaust pressure in the first exhaust operation.

The third exhaust operation is performed while the electromagnetic valve 64a of the first exhaust system 63a is turned on and both the electromagnetic valve 64a of the first exhaust system 63a and the electromagnetic valve 64b of the second exhaust system 63b are turned on at the timing when the Z-direction position of the fine-motion stage 12a reaches the second position. In this case, the first set value and the third set value are the same pressure value. Equalizing the first set value and the third set value can improve the throughput without increasing the number of pipe systems. However, limitation is not made thereto, and the first set value and the third set value may be made different from each other. In this case, the present disclosure may use an arrangement (three-system pipe arrangement) provided with a third exhaust system in addition to the first exhaust system 63a and the second exhaust system 63b. ON/OFF-controlling the three electromagnetic valves provided for the three-system pipe arrangement can make the first set value, the second set value, and the third set value different from each other. For example, all the three electromagnetic valves are turned on in the first exhaust operation, only the one electromagnetic valve is turned on in the second exhaust operation, and only the two electromagnetic valves are turned on in the third exhaust operation. Obviously, electromagnetic valves and regulators may be replaced with servo valves and proportional electromagnetic valves without adding any pipe. Changing the opening degree in the first exhaust operation and the third exhaust operation can change the exhaust pressure in each exhaust operation.

The substrate mounting process according to this embodiment has exemplified the case where exhaust operation switching is performed while the fine-motion stage 12a is moved. However, limitation is not made thereto. For example, the first exhaust operation may be performed while the fine-motion stage 12a is moved, the movement of the fine-motion stage 12a may be temporarily stopped at the timing when the Z-direction position of the fine-motion stage 12a reaches the first position, and the first exhaust operation may be switched to the second exhaust operation in this state. That is, switching from the first exhaust operation to the second exhaust operation may be performed while reduction in the protrusion amount of the pins 13 from the holding surface 11a of the substrate chuck 11 is temporarily stopped. In addition, after the second exhaust operation is started, the movement of the fine-motion stage 12a is resumed. The movement of the fine-motion stage 12a may be temporarily stopped at the timing when the Z-direction position of the fine-motion stage 12a reaches the second position, and the second exhaust operation may be switched to the third exhaust operation in this state.

In addition, in the substrate mounting process according to this embodiment, the moving speed of the fine-motion stage 12a may be changed. In the first exhaust operation, the moving speed of the fine-motion stage 12a is increased to improve the throughput. In the second exhaust operation, the moving speed of the fine-motion stage 12a is reduced to a speed lower than that in the first exhaust operation to reduce the distortion of the substrate S caused by the holding of the substrate S by the substrate chuck 11. In the third exhaust operation, the moving speed of the fine-motion stage 12a is increased to a speed higher than that in the second exhaust operation to quickly store the pins 13 in the substrate chuck 11. Changing the moving speed of the fine-motion stage 12a stepwise in this manner can more reliably reduce the distortion of the substrate S caused by the holding of the substrate S by the substrate chuck 11 and can be advantageous in throughput.

As described above, in the substrate mounting process according to this embodiment, the third exhaust operation of performing exhaust with the third set value of exhaust pressure larger than the second set value is executed after the second exhaust operation. This can shorten the time taken to hold the substrate S by the substrate chuck 11 by forming a vacuum between the substrate chuck 11 and the substrate S and hence can be advantageous in throughput.

### [Modification]

In the case in Fig. 10 described above, the first position is the Z-direction position of the fine-motion stage 12a when the holding surface 11a and the substrate S start to come into contact with each other. Note, however, that the first position can be the Z-direction position of the fine-motion stage 12a before the holding surface 11a and the substrate S start to come into contact with each other (for example, immediately before the holding surface 11a and the substrate S start to come into contact with each other).

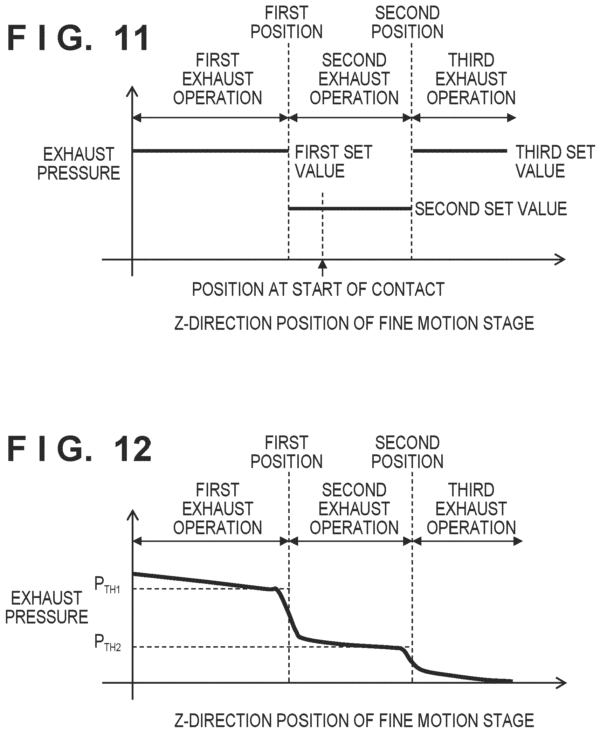

Fig. 11 shows a modification of the exhaust operation in a substrate mounting process. In the case in Fig. 11, the first position is defined as the Z-direction position of the fine-motion stage 12a immediately before the holding surface 11a and the substrate S start to come into contact with each other, and the Z-direction position of the fine-motion stage 12a when the holding surface 11a and the substrate S start to come into contact with each other is indicated after the first position. That is, in the case in Fig. 9, the first exhaust operation is switched to the second exhaust operation at a timing before the holding surface 11a of the substrate chuck 11 and the substrate S start to come into contact with each other. With this operation, the first exhaust operation is switched to the second exhaust operation in a state where a gap exists between the substrate chuck 11 and the substrate S, and hence the distortion of the substrate S caused by the holding of the substrate S by the substrate chuck 11 can be more reliably reduced.

In addition, in the case in Fig. 11, the second position is indicated after the Z-direction position of the fine-motion stage 12a when the holding surface 11a and the substrate S start to come into contact with each other. That is, in the case in Fig. 11, the second exhaust operation is switched to the third exhaust operation at a timing after the holding surface 11a of the substrate chuck 11 and the substrate S start to come into contact with each other. In this case, the second position may be understood as the Z-direction position of the fine-motion stage 12a while the upper surfaces of the pins 13 are lower in level than the holding surface of the substrate chuck 11. This makes it possible to shorten the time taken to hold the substrate S by the substrate chuck 11 by forming a vacuum between the substrate chuck 11 and the substrate S and hence can be advantageous in throughput.

### <Third Embodiment>

The third embodiment of the present disclosure will be described. This embodiment exemplifies a case where exhaust operation switching is performed based on the monitoring result (detection result) obtained by a pressure sensor 62. That is, in the embodiment, exhaust operation switching is performed at the timing when the internal pressure of a pipe 61 monitored (detected) by the pressure sensor 62 reaches a pressure threshold. The internal pressure of the pipe 61 may be understood as an exhaust pressure through exhaust holes 11b. Note that the embodiment basically inherits the first embodiment and can follow the first embodiment except for matters referred to below. The second embodiment of further executing the third exhaust operation may be applied to the third embodiment. The following will describe a case where the second embodiment is applied to the third embodiment.

Fig. 12 shows the monitoring result obtained by the pressure sensor 62 in a substrate mounting process. Referring to Fig. 12, the Z-direction position of a fine-motion stage 12a is represented by the abscissa, and the exhaust pressure (the internal pressure of the pipe 61) detected by the pressure sensor 62 is represented by the ordinate.

In a substrate mounting process, as the protrusion amount of pins 13 from a holding surface 11a of a substrate chuck 11 is reduced to narrower the gap between the substrate chuck 11 and the substrate S in the Z direction, the amount of gas inflowing from the outside to the space between the substrate chuck 11 and the substrate S decreases. As a result, the pressure of the space gradually decreases. In this embodiment, the first exhaust operation is switched to the second exhaust operation at the timing when the exhaust pressure detected by the pressure sensor 62 reaches a first pressure threshold P_{TH1}. The second exhaust operation is switched to the third exhaust operation at the timing when the exhaust pressure detected by the pressure sensor 62 reaches a second pressure threshold P_{TH2}. The first pressure threshold P_{TH1} and the second pressure threshold P_{TH2} can be set in advance by experiments, simulations, or the like. The second pressure threshold P_{TH2} is set to a value smaller than the first pressure threshold P_{TH1}.

Even if exhaust operation switching is performed based on a real-time result, the substrate S may be sucked with the first set value of exhaust pressure without any change depending on the responsiveness of the pressure sensor 62, resulting in the distortion of the substrate S. Accordingly, in this embodiment, the first pressure threshold P_{TH1} and the second pressure threshold P_{TH2} are set in advance. The first exhaust operation is switched to the second exhaust operation at the timing when the exhaust pressure detected by the pressure sensor 62 reaches the first pressure threshold P_{TH1}, and the first exhaust operation is switched to the second exhaust operation at the timing when the exhaust pressure detected by the pressure sensor 62 reaches the second pressure threshold P_{TH2}. Determining the timing of exhaust operation switching by using the monitoring result (detection result) obtained by the pressure sensor 62 in this manner can reduce the sideslipping of the substrate S on the pins 13 and reduce the distortion of the substrate S when the substrate S is held by the substrate chuck 11.

The relationship between the timing of switching the exhaust pressure from the first set value to the second set value and the sideslipping amount of the substrate S on the pins 13 is measured in advance. The first pressure threshold P_{TH1} can be determined to a value that can reduce the sideslipping of the substrate S based on the relationship. The first pressure threshold P_{TH1} may be determined by using a simulation. In addition, the relationship between the timing of switching the exhaust pressure from the second set value to the third set value and the distortion amount of the substrate S is measured in advance. The second pressure threshold P_{TH2} can be determined to a value that can reduce the distortion of the substrate S based on the relationship. The second pressure threshold P_{TH2} may be determined by using a simulation.

### [Modification]

In the case in Fig. 12 described above, the timing of exhaust operation switching is determined based on the monitoring result obtained by the pressure sensor 62. However, a flow rate sensor that monitors (detects) the flow rate of gas flowing in the pipe 61 may be provided instead of the pressure sensor 62, and exhaust operation switching may be performed based on the monitoring result (detection result) obtained by the flow rate sensor. More specifically, the first exhaust operation is switched to the second exhaust operation at the timing when the flow rate monitored (detected) by the flow rate sensor reaches the first flow rate threshold, and the second exhaust operation is switched to the third exhaust operation at the timing when the flow rate monitored (detected) by the flow rate sensor reaches the second flow rate threshold. The flow rate of gas flowing in the pipe 61 may be understood as an exhaust flow rate through the exhaust holes 11b. The first flow rate threshold and the second flow rate threshold can be set in advance by experiments, simulations, or the like, like the first pressure threshold P_{TH1} and the second pressure threshold P_{TH2}. The second flow rate threshold is set to a value smaller than the first flow rate threshold.

### <Fourth Embodiment>

The fourth embodiment of the present disclosure will be described. The first embodiment has exemplified the case where the first exhaust operation is switched to the second exhaust operation in the period from when the protrusion amount of the pins 13 from the holding surface 11a of the substrate chuck 11 starts to decrease until when the holding surface 11a and the substrate S start to come into contact with each other. The fourth embodiment will exemplify a case where the first exhaust operation is switched to the second exhaust operation while a substrate S has already been placed (mounted) on a holding surface 11a of a substrate chuck 11. Note that this embodiment basically inherits the first embodiment and can follow the first embodiment except for matters referred to below. In addition, the second embodiment and/or the third embodiment may be applied to the fourth embodiment.

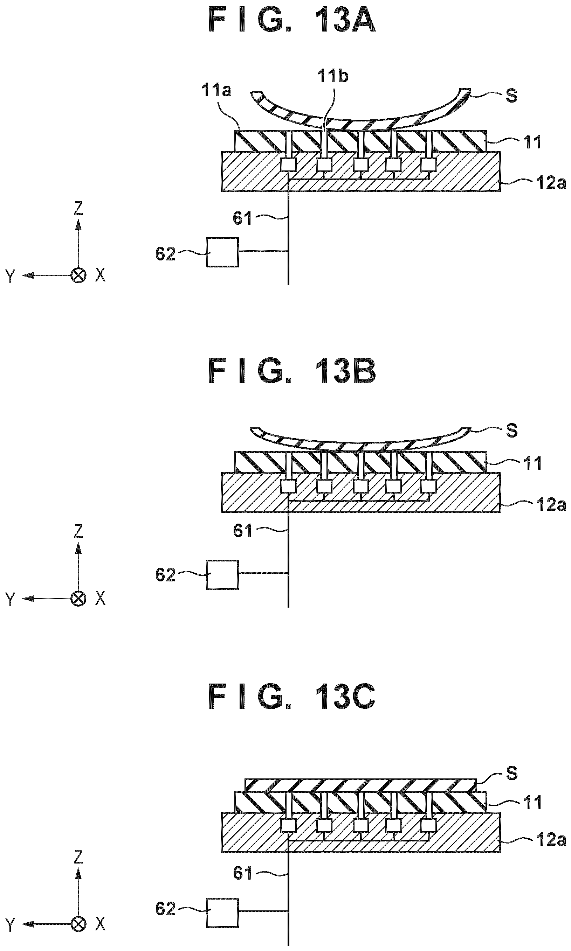

This embodiment configured to switch the first exhaust operation to the second exhaust operation while the substrate S has already been placed (mounted) on the holding surface 11a of the substrate chuck 11 is especially effective in causing the substrate chuck 11 to hold the substrate S having warpage. Figs. 13A to 13C are views for explaining a substrate holding process of causing the substrate chuck 11 to hold the substrate S having warpage. Figs. 13A to 13C show the substrate holding process according to this embodiment in chronological order. Note that the controller 30 can control a substrate holding process.

Fig. 13A shows a state in which the substrate S having warpage is placed on the holding surface 11a of the substrate chuck 11. In this state, the peripheral portion of the substrate S placed on the substrate chuck 11 (the holding surface 11a) is separated from the substrate chuck 11. In this state (that is, when the peripheral portion of the substrate S does not come into contact with the substrate chuck 11), the first exhaust operation is started. This reduces the atmospheric pressure of the space between the substrate chuck 11 and the substrate S and gradually corrects the warpage of the substrate S.

Figs. 13B and 13C show a state in which the warpage of the substrate S is gradually corrected. In this embodiment, the first exhaust operation is switched to the second exhaust operation before the state in Fig. 13B, that is, before (for example, immediately before) the entire substrate S comes into contact with the substrate chuck 11 (the holding surface 11a). This makes it possible to reduce the distortion of the substrate S caused when the substrate chuck 11 is made to hold the substrate S. In addition, after the entire substrate S comes into contact with the substrate chuck 11 (the holding surface 11a), the second exhaust operation may be switched to the third exhaust operation.

An example of the arrangement of the substrate holding unit 10 for holding the substrate S placed on the substrate chuck 11 will be described with reference to Fig. 3. In this embodiment, the first exhaust operation (the first set value of exhaust pressure) is switched to the second exhaust operation (the second set value of exhaust pressure) while the substrate S is placed on the holding surface 11a of the substrate chuck 11. As in the first embodiment, switching from the first exhaust operation to the second exhaust operation can be performed by ON/OFF control of an electromagnetic valve 64a of a first exhaust system 63a and an electromagnetic valve 64b of a second exhaust system 63b. Even in a case where the first exhaust operation is switched to the second exhaust operation while the substrate S has already been placed on the holding surface 11a of the substrate chuck 11, it is possible to reduce the distortion of the substrate S caused when the substrate chuck 11 is made to hold the substrate S.

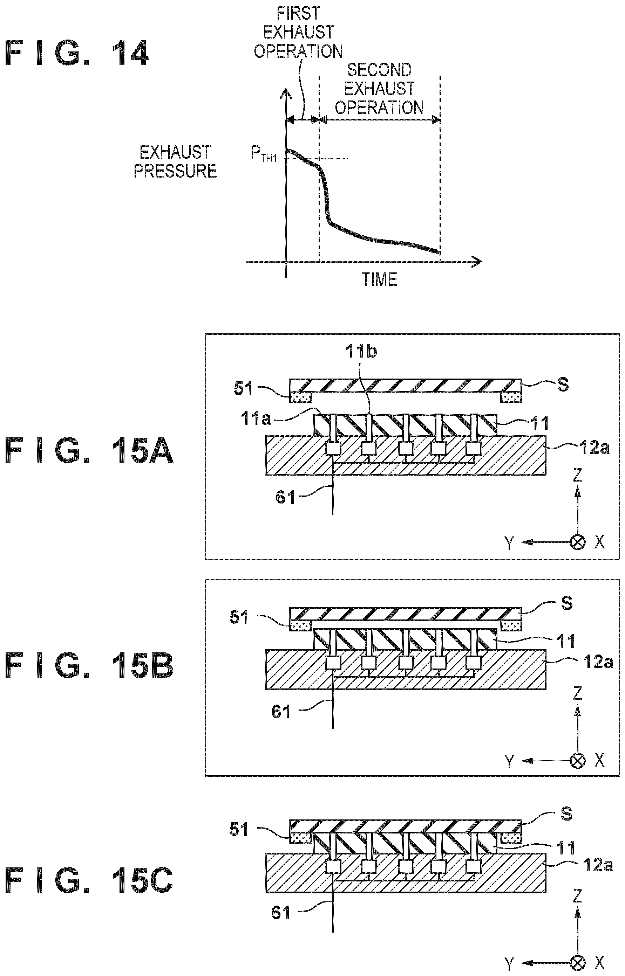

As in the third embodiment, it is possible to determine the timing of switching from the first exhaust operation to the second exhaust operation based on the monitoring result obtained by a pressure sensor 62. For example, when the substrate chuck 11 and the substrate S start to come into contact with each other, the exhaust pressure (the internal pressure of the pipe 61) rapidly changes. Accordingly, depending on the responsiveness of the pressure sensor 62, even if exhaust pressure switching is performed based on a real-time result, the substrate S may be held with a remaining high exhaust pressure, resulting in distortion. In this embodiment, as shown in Fig. 14, a first pressure threshold P_{TH1} is set in advance, and the first exhaust operation is switched to the second exhaust operation at the timing when the exhaust pressure detected by the pressure sensor 62 reaches the first pressure threshold P_{TH1}. Determining the timing of switching from the first exhaust operation to the second exhaust operation based on the monitoring result obtained by the pressure sensor 62 can reduce the distortion of the substrate S caused when the substrate chuck 11 is made to hold the substrate S. The relationship between the timing of switching the exhaust pressure from the first set value to the second set value and the distortion amount of the substrate S is measured in advance. The first pressure threshold P_{TH1} can be determined to a value that can reduce the distortion of the substrate S based on the relationship. The first pressure threshold P_{TH1} may be determined by using a simulation.

In this embodiment, as described in the modification of the third embodiment, a flow rate sensor that monitors (detects) the flow rate of gas flowing in the pipe 61 may be provided instead of the pressure sensor 62, and exhaust operation switching may be performed based on the monitoring result (detection result) obtained by the flow rate sensor. In addition, the embodiment has exemplified the case where the exhaust pressure is switched in two steps in the first exhaust operation and the second exhaust operation. However, as described in the second embodiment, the third exhaust operation may be further performed after the execution of the second exhaust operation, and the exhaust pressure may be switched in three steps.

As described above, in the substrate holding process according to this embodiment, the first exhaust operation is started while the peripheral portion of the substrate S placed on the substrate chuck 11 is separated from above the substrate chuck 11, and the first exhaust operation is switched to the second exhaust operation before the entire substrate S comes into contact with the substrate chuck 11. This makes it possible to reduce the distortion of the substrate S caused when the substrate chuck 11 is made to hold the substrate S. This operation can be advantageous in throughput in comparison with the case where the first exhaust operation is switched to the second exhaust operation after the entire substrate S comes into contact with the substrate chuck 11.

### <Fifth Embodiment>

The fifth embodiment of the present disclosure will be described. The first embodiment has exemplified the case where the supply hand 51 conveys the substrate S onto the pins 13 protruding from the holding surface 11a of the substrate chuck 11. The fifth embodiment will exemplify a case where a supply hand 51 directly conveys a substrate S onto a substrate chuck 11. Note that this embodiment basically inherits the first embodiment and can follow the first embodiment except for matters referred to below. In addition, the second embodiment and/or the third embodiment may be applied to the fifth embodiment.

In this embodiment, a process of mounting the substrate S on the substrate chuck 11 by reducing the gap between the substrate chuck 11 and the substrate S by driving the supply hand 51 holding the substrate S can be defined as a substrate mounting process (substrate mounting step). In the substrate mounting process according to the embodiment, the first exhaust operation is switched to the second exhaust operation in the period from when the gap between the substrate chuck 11 and the substrate S starts to decrease by driving the supply hand 51 until when the substrate chuck 11 and the substrate S start to come into contact with each other.

Figs. 15A to 15C are views for explaining a substrate holding process when the supply hand 51 conveys the substrate S onto the substrate chuck 11. Figs. 15A to 15C show the substrate holding process according to this embodiment in chronological order. Note that the controller 30 can control a substrate mounting process.

Fig. 15A shows a state in which the substrate S held by the supply hand 51 is placed above the substrate chuck 11. In this state, the substrate chuck 11 (a holding surface 11a) is separated from the substrate S. In this state (that is, when the substrate S is supported by the supply hand 51), the first exhaust operation is started. In this case, the supply hand 51 according to this embodiment is configured to hold the lower surface of the substrate S by vacuum suction. However, limitation is not made thereto, and the supply hand 51 may be configured to hold the upper surface of the substrate S by vacuum suction.

Figs. 15B and 15C show a state in which the gap between the substrate chuck 11 and the substrate S is narrowed as the supply hand 51 is driven in the -Z direction. In this embodiment, the first exhaust operation is switched to the second exhaust operation in the state in Fig. 15B, that is, before (for example, immediately before) the substrate chuck 11 (the holding surface 11a) and the substrate S start to come into contact with each other. This makes it possible to reduce the distortion of the substrate S caused when the substrate chuck 11 is made to hold the substrate S. In addition, after the substrate chuck 11 (the holding surface 11a) and the substrate S start to come into contact with each other, the second exhaust operation may be switched to the third exhaust operation.

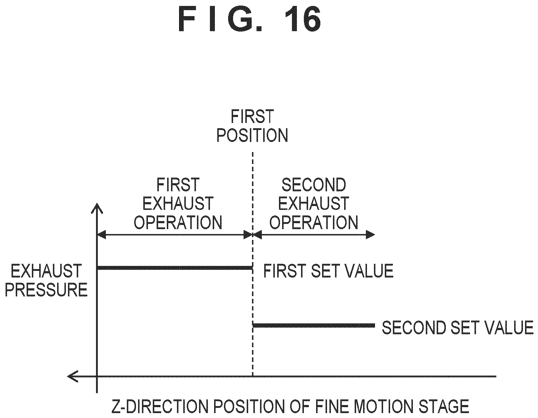

Fig. 16 shows an example of the first exhaust operation and the second exhaust operation in a substrate mounting process. Referring to Fig. 16, the Z-direction position of the supply hand 51 is represented by the abscissa, and the exhaust pressure is represented by the ordinate.

In the substrate mounting process according to this embodiment, the first exhaust operation is started at the start of driving the supply hand 51 in the -Z direction while the supply hand 51 holds the substrate S above the substrate chuck 11. In the first exhaust operation, exhaust is performed with the first set value of exhaust pressure so as to reduce the sideslipping of the substrate S on the supply hand 51 due to the wind pressure generated upon movement of the supply hand 51 at a high speed. The first set value is set to a value that can make the sideslipping amount (shift amount) of the substrate S on the supply hand 51 fall within an allowable range in the period from when the supply hand 51 starts to be driven in the -Z direction until when the holding surface 11a of the substrate chuck 11 and the substrate S start to come into contact with each other. This makes it possible to reduce the sideslipping of the substrate S on the supply hand 51.

The exhaust amount in the first exhaust operation (the flow rate of gas exhausted through exhaust holes 11b) is preferably equal to or higher than the flow rate of gas extruded from the space on the substrate chuck 11 upon driving of the supply hand 51 in the -Z direction (to be sometimes referred to as a gas extrusion amount hereinafter). Note, however, that it may be difficult to make the exhaust amount in the first exhaust operation be equal to or larger than the gas extrusion amount depending on the placement of a pipe system in the apparatus. In this case, the exhaust amount in the first exhaust operation is preferably set in consideration of the holding of the substrate S by the supply hand 51. For example, since the substrate S is sucked by the supply hand 51 by vacuum suction, it is possible to reduce the sideslipping of the substrate S on the supply hand 51 as long as the exhaust amount in the first exhaust operation is equal to or larger than the value obtained by subtracting the vacuum suction amount of the substrate S by the supply hand 51 from the gas extrusion amount.

The second exhaust operation is started at the timing when the Z-direction position of the supply hand 51 reaches the first position. That is, the first exhaust operation is switched to the second exhaust operation at this timing. In the second exhaust operation, exhaust is performed with the second set value of exhaust pressure smaller than the first set value so as to reduce the distortion of the substrate S caused by the holding the substrate S by the substrate chuck 11. The second set value is set to a value that can make the distortion amount of the substrate S caused by the holding of the substrate S by the substrate chuck 11 fall within an allowable range. This makes it possible to reduce the distortion of the substrate S caused by the holding of the substrate S by the substrate chuck 11. In addition, providing the second exhaust operation makes it possible to reduce the frictional force between the holding surface 11a of the substrate chuck 11 and the substrate S and reduce the wear of the substrate chuck 11. In this case, the first position is defined as the Z-direction position of the supply hand 51 when the holding surface 11a of the substrate chuck 11 and the substrate S start to come into contact with each other, or a position closer to the +Z direction side than such the Z-direction position. The first position is obtained in advance by experiments, simulations, or the like and stored in the controller 30 (the memory unit 32).

As described above, in the substrate mounting process according to this embodiment, the first exhaust operation is switched to the second exhaust operation in the period from when the gap between the substrate chuck 11 and the substrate S starts to decrease by driving the supply hand 51 until when the substrate chuck 11 and the substrate S start to come into contact with each other. Since the sideslipping of the substrate S on the supply hand 51 is reduced by the first exhaust operation, a substrate mounting process can be performed without reducing the driving speed of the supply hand 51. This can be advantageous in throughput. The second exhaust operation can then reduce the distortion of the substrate S caused when the substrate S comes into contact with the holding surface 11a of the substrate chuck 11. In addition, the first exhaust operation is switched to the second exhaust operation at a timing when or before the holding surface 11a and the substrate S start to come into contact with each other. This can be advantageous in throughput. That is, the substrate mounting process according to this embodiment is advantageous in the distortion of the substrate S and throughput in a substrate holding process.

### <Embodiment of Article Manufacturing Method>

An article manufacturing method according to the embodiment of the present disclosure is suitable to, for example, manufacture an article such as a microdevice such as a semiconductor device or an element having a microstructure. The article manufacturing method according to this embodiment includes a processing step of processing a substrate by using the above substrate processing apparatus and the substrate processing method and a manufacturing step of manufacturing an article from a substrate processed in the processing step. The article manufacturing method also includes other known steps (oxidation, deposition, vapor deposition, doping, planarization, etching, resist peeling, dicing, bonding, and packaging). The article manufacturing method according to this embodiment is advantageous in at least one of the performance, quality, productivity, and production cost of an article as compared to a conventional method.

### <Other Embodiments>

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processor (CPU), micro processor (MPU), or the like) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

While the present disclosure has been described with reference to exemplary embodiments, it is to be understood that the disclosure is not limited to the disclosed exemplary embodiments. The scope of the following claims is to be accorded the broadest interpretation so as to encompass all such modifications and equivalent structures and functions.

## Claims

1. A substrate holding apparatus (10) that holds a substrate (S), the apparatus comprising:
a chuck (11) configured to support the substrate;
pins (13) configured to protrude from the chuck; and
a controller (30) configured to control exhaust of a space between the substrate and the chuck,
wherein the controller is configured to control the exhaust to perform a first exhaust operation of exhausting gas from the space with a first exhaust pressure, and after the first exhaust operation, perform a second exhaust operation of exhausting gas from the space with a second exhaust pressure lower than the first exhaust pressure, and
wherein the second exhaust operation is performed in a period from when a protrusion amount of the pins start to decrease until when the chuck and the substrate come into contact with each other.

2. The apparatus according to claim 1, wherein the first exhaust operation is switched to the second exhaust operation at a timing when or before the chuck and the substrate start to come into contact with each other.

3. The apparatus according to claim 1 or 2, wherein
the first exhaust operation is started in a state where a gap exists between the chuck and the substrate, and
the first exhaust pressure is set to a value that enables a shift amount of the substrate on the pins to fall within an allowable range.

4. The apparatus according to any one of claims 1 to 3, wherein the second exhaust pressure is set to a value that enables a distortion amount of the substrate caused by supporting the substrate by the chuck to fall within an allowable range.

5. The apparatus according to any one of claims 1 to 4, wherein the controller is configured to control the exhaust to, after the second exhaust operation, further perform a third exhaust operation of exhausting gas from the space with a third exhaust pressure higher than the second exhaust pressure.

6. The apparatus according to claim 5, wherein the third exhaust pressure is not more than the first exhaust pressure.

7. The apparatus according to claim 5 or 6, wherein the third exhaust operation is started after the chuck and the substrate start to come into contact with each other.

8. The apparatus according to any one of claims 1 to 7, wherein the first exhaust operation is switched to the second exhaust operation while the protrusion amount of the pins from the chuck decreases.

9. The apparatus according to any one of claims 1 to 7, wherein the first exhaust operation is switched to the second exhaust operation while reduction in the protrusion amount of the pins from the chuck is stopped.

10. The apparatus according to any one of claims 1 to 9, wherein the first exhaust operation is switched to the second exhaust operation in accordance with the protrusion amount of the pins from the chuck.

11. The apparatus according to any one of claims 1 to 9, further comprising a sensor configured to detect an exhaust pressure,
wherein the first exhaust operation is switched to the second exhaust operation in accordance with a detection result of the sensor.

12. The apparatus according to any one of claims 1 to 9, further comprising a flow rate sensor configured to detect a flow rate of gas exhausted from the space,
wherein the first exhaust operation is switched to the second exhaust operation in accordance with a detection result of the flow rate sensor.

13. A substrate holding apparatus (10) that holds a substrate (S), the apparatus comprising:
a chuck (11) configured to support the substrate; and
a controller (30) configured to control exhaust of a space between the substrate and the chuck,
wherein the controller is configured to control the exhaust to perform a first exhaust operation of exhausting gas from the space with a first exhaust pressure, and after the first exhaust operation, perform a second exhaust operation of exhausting gas from the space with a second exhaust pressure lower than the first exhaust pressure, and
wherein the first exhaust operation is started when a peripheral portion of the substrate placed on the chuck does not come into contact with the chuck, and the second exhaust operation is performed before the entire substrate comes into contact with the chuck.

14. A substrate processing apparatus that processes a substrate (S), the apparatus comprising:
a substrate holding apparatus (10) defined in any one of claims 1 to 13; and
a processor (20) configured to process the substrate held by the substrate holding apparatus.

15. A substrate holding method of holding a substrate (S), the method comprising:
performing a first exhaust operation of exhausting gas from a space between the substrate and a chuck (11) configured to support the substrate, with a first exhaust pressure; and
performing, after the first exhaust operation, a second exhaust operation of exhausting gas from the space with a second exhaust pressure lower than the first exhaust pressure,
wherein the second exhaust operation is performed in a period from when a protrusion amount of pins (13) configured to protrude from the chuck start to decrease until when the chuck and the substrate come into contact with each other.

16. The method according to claim 15, wherein the first exhaust operation is performed when the substrate is supported by a conveyance hand (51).

17. A substrate processing method of processing a substrate, the method comprising:
causing a chuck (11) to hold the substrate by using a substrate holding method defined in claim 15; and
processing the substrate held by the chuck.

18. An article manufacturing method comprising:
processing a substrate by using a substrate processing method defined in claim 17; and
manufacturing an article from the processed substrate.
